(19) Europäisches Patentamt
European Patent Office
Office européen des brevets

(11) **EP 2 224 464 A1**

(12) **EUROPEAN PATENT APPLICATION**
published in accordance with Art. 153(4) EPC

(43) Veröffentlichungstag:
**01.09.2010 Patentblatt 2010/35**

(51) Int Cl.:
***H01J 37/153*** *(2006.01)*

(21) Anmeldenummer: **08741782.0**

(86) Internationale Anmeldenummer:
**PCT/RU2008/000007**

(22) Anmeldetag: **11.01.2008**

(87) Internationale Veröffentlichungsnummer:
**WO 2009/045121 (09.04.2009 Gazette 2009/15)**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **03.10.2007 RU 2007136718**

(71) Anmelder: **Sachenko, Viacheslav Danilovich**
**Ul. Sikeirosa 13-340**
**St.Petersburg 194354 (RU)**

(72) Erfinder: **Sachenko, Viacheslav**
**38678 Clausthal-Zellerfeld (DE)**

(74) Vertreter: **Einsel, Martin et al**
**Patentanwälte Einsel & Kollegen**
**Jasperallee 1a**
**38102 Braunschweig (DE)**

(54) **KORPUSKULARES OPTISCHES BILDERZEUGUNGSSYSTEM**

(57) Die Erfindung betrifft den elektronenoptischen Gerätebau und kann bei der Konstruktion korpuskularoptischer Systeme zur Erzeugung visueller Abbildungen von Mikroobjekten eingesetzt werden. Die Vorrichtung weist eine Vakuumkammer auf. In der Kammer befindet sich ein Arbeitstisch mit einer Lichtquelle, sowie in Bildübertragungsrichtung angeordnet, ein Objektiv, ein dispersiver magnetischer Deflektor, ein Aberrations-Korrektor, eine Übertragungslinsen-Einheit, eine Projektions-Einheit und ein Kompensator der energetischen Winkeldispersion. Die optische Achse ist über den dispersiven magnetischen Deflektor mit den optischen Achsen des Objektivs und des Aberrations-Korrektors gekoppelt. Auf dem Bildübertragungsweg vom ersten magnetischen Deflektor zum Aberrations-Korrektor ist der Kompensator der energetischen Winkeldispersion positioniert. Der Kompensator enthält eine seriell in Bildübertragungsrichtung angeordnete axialsymmetrische Steuerlinsen-Einheit. Die Steuerlinsen-Einheit umfasst mindestens zwei Linsen und ist ausgebildet auf der Basis der Berechnung der Bildübertragung ins Zentrum eines zweiten magnetischen Deflektors, wobei der Koeffizient für die optische Vergrößerung gleich 1 ist, und mit Bildung einer negativen Rückkopplung hinsichtlich der energetischen Winkeldispersion. Das technische Ergebnis ist ein höheres Auflösungsvermögen.

EP 2 224 464 A1

## Beschreibung

Die Erfindung betrifft den elektronenoptischen Instrumentenbau und kann bei der Konstruktion korpuskular-optischer Systeme zur Erzeugung visueller Abbildungen von Mikroobjekten eingesetzt werden. Vorrangiges Einsatzgebiet ist die Elektronenmikroskopie von Objekten der Mikro- und Nano-Technologie. Möglich ist eine Verwendung der Erfindung auch in anderen Vorrichtungen, bei denen die Fokussierung des Strahls geladener Teilchen erforderlich ist, insbesondere in Vorrichtungen für die Mikro- und Nano-Lithographie, im Ionen-Mikroskop und anderen Geräten, bei denen eine Fokussierung von Korpuskular-(Elektronen- und Ionen-) Strahlen, eine Erzeugung und Übertragung von korpuskularen Bildern erfolgt.

Bekannt ist ein korpuskular-optisches Bildgebungssystem, welches eine Vakuum-Kammer aufweist, in die eine Probe, eine Lichtquelle zu deren Beleuchtung und, seriell entlang der Übertragungsrichtung des Bildes der Probe angeordnet, ein Objektiv, ein als magnetischer Multipol ausgebildeten Korrektor der sphärischen Komponente der sphärisch-chromatischen Aberration , und eine Projektions-Einheit eingebracht sind (s. zum Beispiel: EP 1 313 125, H01J37/10, 37/153, 37/28, 37/04, 2003; EP 1770752, H01J37/26, 37/153, 37/04, 2007).

Bei der Anwendung der genannten Konstruktion entsteht jedoch ein Astigmatismus des Bildes, verbunden damit, dass die Multipol-Geometrie keine axialsymmetrische Einwirkung auf das übertragene Bild zulässt. Außerdem, die Gewährleistung der Möglichkeit zu einer Korrektur der chromatischen Komponente der sphärischen chromatischen Aberration ist verbunden mit einer erheblichen Verkomplizierung der Konstruktion des Multipol-Korrektors.

Bekannt ist auch ein korpuskular-optisches Bildgebungssystem, welches eine Vakuum-Kammer aufweist, in die eine Probe, eine Lichtquelle zu deren Beleuchtung, sowie, seriell entlang der Übertragungsrichtung des Bildes der Probe angeordnet, ein Objektiv, ein als elektrostatischer Energie-Filter oder Wien-Filter ausgebildeter Korrektor der chromatischen Komponente der sphärisch-chromatischen Aberration und eine Projektions-Einheit eingebracht sind (s. beispielsweise: US 2004188613, H01J37/22, 37/05, 37/147, 37/28, 37/04, 2004; JP 2005310512, H01J37/29, 37/21, 37/244, 37/295, 37/26, 37/02, 2005; DE 60032972D, H01J37/05, 37/26, 49/48, 37/04, 2007).

Allerdings führt die Verwendung eines Energie-Filters zu einer signifikanten Verringerung der Empfindlichkeit des Systems, bedingt durch die Verluste bei der Energie-Filtration. Dabei verbleibt eine nicht kompensierte Komponente der sphärischen chromatischen Aberration, was die Qualität des erhaltenen Bildes beeinträchtigt.

Zur Verbesserung der Auflösung und der Erweiterung der analytischen Möglichkeiten weist das korpuskular-optische Bildgebungssystem eine Vakuum-Kammer auf, in welche eine Elektronenkanone als Quelle des Elektronenstrahls, ein dispersiver magnetischer Deflektor, ein Funktionselement zum Scannen der Maske der Probe, ein Objektiv und eine Fokussier-Einheit, eingerichtet mit der Möglichkeit der Übertragung eines verkleinerten Bildes der Maske auf eine besprühbare Basis eingebracht sind (s. zum Beispiel: US 2003183781, G21K1/093, H01J37/317, G21K1/00, 2003; JP 2005228743, H01L21/66, G01N23/203, H01J37/147, 37/29, 37/26, 2005). Die beschriebene Konstruktion kann auch in Elektronenmikroskopen zur Erzeugung und Übertragung eines vergrößerten Bildes der Probe verwendet werden (Surface Review and Letters, Vol. 5, Nr. 6 (1998), p. 1191). Dabei erlaubt es das Vorhandensein der Elektronenkanone, die Leuchtenergie durch eine Änderung des Potentials an der Oberfläche der Probe zu steuern.

Am nächstliegenden zum angemeldeten ist ein korpuskular-optisches Bildgebungssystem, welches ein Vakuum-System, einen Arbeitstisch mit einer Probe, eine Lichtquelle für die vorliegende Probe, ein Objektiv und seriell in Übertragungsrichtung des durch das Objektiv erzeugten Bildes angeordneten, einen dispersiven magnetischen Deflektor mit einem Drehwinkel der optischen Achse von 90°, einen Aberrations-Korrektor, der auf der Basis eines axialsymmetrischen elektrostatischen Aberrationsspiegels ausgebildet ist, eine Übertragungslinsen-Einheit und eine Projektions-Einheit aufweist (s. beispielsweise JP 5205687, H01J37/12, 37/04, 37/153, 37/26, 37/29, 37/10, 1993; US 5319207, H01J37/153, 37/04, 37/147, 37/29, 1994). In diesem System ist die Idee der Verbesserung seines Auflösungsvermögens auf dem Wege der Korrektur der sphärisch-chromatischen Aberration des Objektivs auf dem Wege der Übertragung des Bildes der Probe ohne Astigmatismus realisiert.

Wir haben festgestellt, dass in einem Prototyp des Systems der positive Effekt in einem bedeutenden Maße deutlich abgemindert wird durch eine begleitende quadratische chromatische Aberration, die proportional dem Koeffizienten der chromatischen Aberration des aberrativen elektrostatischen Spiegels ist. Der aufgezeigte negative Faktor entsteht im Ergebnis der Dispersivität des magnetischen Deflektors, wodurch der elektronische Informationsstrahl nach dem Austreten aus dem Magnetfeld des magnetischen Deflektors in das Feld des axialsymmetrischen elektrostatischen Aberrationsspiegels eintritt, mit einer zusätzlichen Winkelabweichung, proportional dem Koeffizienten der energetischen Winkeldispersion des magnetischen Deflektors. Deshalb kommt es als Folge des Vorhandenseins einer chromatischen Aberration des axialsymmetrischen elektrostatischen Aberrationsspiegels, die proportional dem Produkt aus der Größe energetischen Inhomogenität und der Winkelverteilung des elektronischen Informationsstrahls ist, ohne eine Abhängigkeit von den die genannte Winkelverteilung auslösenden Ursachen (der anfänglichen Divergenz des elektronischen Informationsstrahls, oder der im magnetischen Deflektor entstandenen energetischen Winkeldispersion), sowohl zum Kompensieren des sphärisch-chromatischen Abbildungsfehlers (eine nützliche Funktion), aber auch zum gleichzeitigen Entstehen einer bedeutsamen quadratischen chromatischen Aberration (ein Nachteil). Mehr noch, die entstandene chromatische Aberration, die proportional ist dem Quadrat der energetischen Inhomogenität des elektronischen Informationsstrahls, kann durch die axialsymmetrischen korpuskular-optischen Elemente nicht kompensiert werden, da es ihnen an einem derartigen Typ von Aberration fehlt. Folglich, die entstandene quadratische chromatische Aberration, die proportional dem Koeffizienten der chromatischen Aberration des axialsymmetrischen elektrostatischen Aberrationsspiegels ist, stellt eine negative Folge des Versuchs dar, den axialsymmetrischen elektrostatischen Aberrationsspiegel für die Korrektur der sphärischen chromatischen Aberration zu benutzen. Aus der Physik dieses Phänomens wird deutlich, dass der genannte negative Effekt auch bei der Nutzung des dispersiven magnetischen Deflektors auftreten wird, bei beliebigem Drehwinkel der optischen Achse.

In diesem Zusammenhang ist die Ausgestaltung eines dispersionslosen magnetischen Deflektors auf der Basis seiner Ausrüstung mit sechs unabhängigen Magnetkernen mit aufeinanderfolgendem Wechsel der magnetischen Pole zu nennen (s. beipielsweise: US 4740704, H01J37/04, 37/05, ***3/14, G21K1/08, 1988; EP0647960, H01J37/05, 49/46, 1994; Journal of Electron Microskopy, v. 46, Nr. 1, 1997, p. 9; Surface Review and Letters, Vol. 5, Nr. 6 (1998), p. 1251). Jedoch eine solche technische Lösung ist in der Ausführung und Einstellung außerordentlich kompliziert und schließt die Entstehung zusätzlicher, unkontrollierter Aberrationen nicht aus, die mit der Realisierung verbunden sind. Außerdem, bei der beschriebenen technischen Lösung beseitigt man im Zuge der Beseitigung der energetischen Winkeldispersion auch die lineare Dispersion, deren Vorhandensein außerordentlich nützlich für die Begrenzung einer hochintensiven parasitären Komponente des elektronischen Informationsstrahls in der Ebene des kontrastverbessernden Apertur-Diaphragmas ist. Daher wird bei dieser technischen Lösung für die Wiederherstellung der verlorenen Funktion hinter dem dispersionslosen magnetischen Deflektor ein "Omega-Filter" positioniert, welcher aus vier seriell angeordneten unabhängigen magnetischen Deflektoren besteht, wobei jeder von diesen durch drei unabhängige Magnetspulen für eine astigmatische Übertragung des opto-elektronischen Bildes angeregt wird, wobei, je komplizierter das korpuskular-optische System ist, desto mehr wird es auch belastet.

Davon ausgehend, ist die Erhaltung der dispersiven Funktion des magnetischen Deflektors äußerst wichtig und wünschenswert, aber in einer Reihe von Fällen (z. B. bei der Untersuchung kristalliner Strukturen einer Probe mittels diffraktiver Methoden) unbedingt erforderlich.

Technische Aufgabe des vorgeschlagenen korpuskular-optischen Systems ist die Verbesserung des Auflösungsvermögens auf dem Wege des Ausschlusses der Ursachen für die Entstehung einer quadratischen chromatischen Aberration bei Erhaltung der korrigierenden Funktion des Aberrations-Korrektors unter den Bedingungen der Verwendung eines dispersiven magnetischen Deflektors.

Die Lösung der genannten technischen Aufgabe besteht darin, dass das korpuskular-optische Bildgebungssystem ein Vakuum-System, einen Arbeitstisch mit einer Probe, eine Lichtquelle zur Beleuchtung der vorliegenden Probe, ein Objektiv aufweist, sowie, seriell angeordnet in Richtung der Übertragung des durch das Objektiv erzeugten Bildes, einen dispersiven magnetischen Deflektor, einen Aberrations-Korrektor, ausgebildet auf der Basis eines axialsymmetrischen elektrostatischen Aberrationsspiegels, eine Übertragungslinsen-Einheit, eine Projektions-Einheit, und dass auf dem Bildübertragungsweg vom magnetischen Deflektor zum Aberrations-Korrektor ein Kompensator der energetischen Winkeldispersion positioniert ist.

Ausgehend davon, dass der Kompensator der energetischen Winkeldispersion aus dem bisherigen Stand der Technik nicht bekannt ist, werden folgende Varianten seiner Ausgestaltung vorgeschlagen:

1. Der Kompensator der energetischen Winkeldispersion besteht aus, seriell in Bildübertragungsrichtung angeordnet, einer axialsymmetrischen Steuerlinsen-Einheit und einem axialsymmetrischen elektrostatischen Spiegel, die auf den Modus für eine aberrationsfreie Bildübertragung in das Zentrum des magnetischen Deflektors eingestellt sind, wobei der Koeffizient für die optische Vergrößerung gleich 1 ist, und wobei eine negative Rückkopplung hinsichtlich der energetischen Winkeldispersion erzeugt wird (gem. Anspruch 1).

In dieser Variante des Kompensators der energetischen Winkeldispersion existiert nach dem Durchlaufen des elektrostatischen Spiegels durch den elektronischen Informationsstrahl die Gefahr des Entstehens einer quadratischen chromatischen Aberration, verbunden mit dem Vorhandensein einer energetischen Winkeldispersion des elektronischen Informationsstrahls am Eingang des Kompensators der energetischen Winkel-Dispersion. Zur Beseitigung der Entstehungsmöglichkeiten der genannten Aberrationen werden die Steuerlinsen-Einheit und der axialsymmetrische Spiegel des Kompensators der energetischen Winkel-Dispersion auf den Modus der aberrationsfreien Bildübertragung ins Zentrum des magnetischen Deflektors eingestellt. Eine solche Einstellung wird mittels Regulierung der Spannung realisiert, die an die Elektroden des elektrostatischen Spiegels und der Steuerlinsen-Einheit angelegt wird.

In der beschriebenen Variante des Kompensators der energetischen Winkeldispersion ist es zweckmäßig, den magnetischen Deflektor mit einem Drehwinkel der optischen Achse für Vielfache von 36° zu realisieren, zwecks Erhalt von fünf optischen Kanälen, wobei in einem von ihnen die Elektronenkanone positioniert werden kann (gem. Anspruch 2).

2. Der Kompensator der energetischen Winkeldispersion besteht aus, seriell in Bildübertragungsrichtung angeordnet, einer axialsymmetrischen Steuerlinsen-Einheit und einem zweiten magnetischen Deflektor, der identisch zu dem ersten (vorhandenen) magnetischen Deflektor ausgebildet ist, wobei die Steuerlinsen-Einheit ausgestaltet ist auf der Basis der Berechnung der Bildübertragung ins Zentrum des zweiten magnetischen Deflektors bei einem Koeffizienten für die optische Vergrößerung gleich 1, mit Erzeugung einer negativen Rückkopplung hinsichtlich der energetischen Winkeldispersion (gem. Anspruch 3). Zur Begründung der erforderlichen Anzahl von Linsen im Bestand der Steuerlinsen-Einheit bei dieser Variante des Kompensators der energetischen Winkeldispersion dient die Berechnungstabelle für die aberrativen Eigenschaften der Steuerlinsen-Einheit, für den Fall der Verwendung in ihr einer Linse (Vergleichsobjekt) und zweier Linsen (elektrostatischer oder magnetischer) im Modus der direkten Bildübertragung und mit Zwischenbild, übertragen mittels der Steuerlinsen-Einheit. Obwohl dabei die Ausgestaltung der Steuerlinsen-Einheit auf der Basis einer magnetischen Linse technisch möglich ist, wird jedoch unausweichlich eine nicht kompensierbare Drehung des optischen Bildes im Verlaufe seiner Übertragung durch die Steuerlinsen-Einheit hervorgerufen, was im vorliegenden Fall einen Defekt darstellt. In den Varianten der Steuerlinsen-Einheit mit zwei Magnetlinsen ist eine Kompensation der Drehung des optischen Bildes möglich und wird auf dem Wege der Realisierung von gegensätzlichen Stromrichtungen in den Spulen der verwendeten Linsen erreicht.

Die Daten in der Tabelle entsprechen einer Entfernung zwischen den Zentren der magnetischen Deflektoren vom 500 mm, aber die Brennweiten der Linsen entsprechen dem Übertragungs-Modus der elektronenoptischen Bilder mittels der Steuerlinsen-Einheit aus dem Zentrum des ersten magnetischen Deflektors in das Zentrum des zweiten magnetischen Deflektors bei einem Koeffizienten der optischen Vergrößerung gleich 1.

Wie aus der Tabelle ersichtlich, ist die Variante der Ausgestaltung der Steuerlinsen-Einheit auf der Basis einer (elektrostatischen) Linse ist charakterisiert durch einen signifikanten Koeffizienten für die sphärische Aberration ($93,7 \times 10^4$ mm). Das beruht darauf, dass bei dieser Variante die Lage der verwendeten Linse streng determiniert ist, d. h. sie kann genau in der Mitte zwischen dem ersten und dem zweiten magnetischen Deflektor positioniert sein. Im Zusammenhang damit soll die Linse ausreichend schwach sein (mit einer großen Brennweite), wodurch sich auch der erhöhte Pegel der sphärischen Aberration des übertragenen Bildes erklärt. Aus der Tabelle ist ebenfalls ersichtlich, dass im Vergleich mit der einlinsigen Variante der Steuerlinsen-Einheit die zweilinsige Konstruktion deutlich vorteilhafter erscheint. Insbesondere verringert sich bei der elektrostatischen Ausführung der Steuerlinsen-Einheit der Koeffizient der sphärischen Aberration um das 15-fache, aber in der magnetischen Variante - um mehr als das 33 -fache. Ein solcher spürbarer Vorteil der zweilinsigen Variante der Steuerlinsen-Einheit erklärt sich dadurch, dass die Verwendung von zwei Linsen für eine direkte Bildübertragung (ohne Erzeugung eines Zwischenbildes) es erlaubt, einen Modus mit minimalen aberrativen Störungen zu realisieren, bei welchem die Linsen symmetrisch zur Mitte zwischen dem ersten und zweiten magnetischen Deflektor angeordnet sind, in einer Entfernung von ihnen, die der Brennweite der vorgegeben Linsen entspricht. Eine noch bessere Qualität der Bildübertragung durch die Steuerlinsen-Einheit lässt sich durch einen etwas komplizierteren Aufbau der Steuerlinsen-Einheit mittels der Verwendung in ihr von vier Linsen, die symmetrisch angeordnet sind bezüglich der Mitte zwischen den magnetischen Deflektoren. Dabei ist die Lösung der Aufgabe zur Erhöhung der Qualität des durch die Steuerlinsen-Einheit übertragenen Bildes durch die Ausführung der Steuerlinsen-Einheit auf der Basis von Magnetlinsen mit einer Kompensation der summarischen Drehung des Bildes immer vorteilhafter, als die Ausführung der Steuerlinsen-Einheit auf der Basis von elektrostatischen Linsen, obwohl die letzteren konstruktiv einfacher sind. Im Modus mit Erzeugung eines Zwischenbildes, welcher prinzipiell nicht unter den Bedingungen nur einer Linse realisiert werden kann, ist der Koeffizient der sphärischen Aberration größer, als im Falle einer direkten Übertragung des Bildes. Jedoch auch in diesem Modus, wie aus den in der Tabelle angeführten Daten ersichtlich ist, ist er um eine Ordnung niedriger, als bei der Ausführung der Steuerlinsen-Einheit mit einer (elektrostatischen) Linse.

Der Übergang in den Modus mit Zwischenbild wird auf dem Wege der Änderung der Spannung an den mittleren Elektroden der elektrostatischen Linsen realisiert oder durch eine Vergrößerung des Stromes der Spulen der Magnetlinsen.

In diesem Modus eröffnet sich die Möglichkeit der Positionierung eines Feld-Diaphragmas zur Verringerung des Rauschpegels am Ausgang des korpuskular-optisches Systems, der bedingt ist durch die Emission überflüssiger Elektronen von dem beleuchteten Bereich der zu untersuchenden Probe im Modus der Erzeugung eines vergrößerten (20 - 200 tausendfach) Bildes eines Mikroobjektes an der Oberfläche der Probe, und der Vereinfachung des Einstellens der Elemente des korpuskular-optischen Systems (gem. Anspruch 5).

In dieser Variante des Kompensators der energetischen Winkel-Dispersion ist daher das Vorhandensein von mindestens zwei Linsen eine zwingende Bedingung für die Erhöhung der Qualität des durch ihn übertragenen Bildes

3. Der Kompensator der energetischen Winkel-Dispersion besteht aus, seriell entlang der Bildübertragungsrichtung angeordnet, einer axialsymmetrischen Steuerlinsen-Einheit und einem zweiten magnetischen Deflektor, welcher nicht identisch mit dem ersten magnetischen Deflektor ausgestaltet ist, wobei die Steuerlinsen-Einheit ausgestaltet ist auf der Basis der Berechnung der Bildübertragung ins Zentrum des zweiten magnetischen Deflektors bei einem Koeffizienten für die optische Vergrößerung gleich dem Verhältnis der Sinus-Werte der Drehwinkel der optischen Achsen des ersten und zweiten magnetischen Deflektors, mit Bildung einer negativen Rückkopplung hinsichtlich der energetischen Winkel-Dispersion (gem. Anspruch 4). Wenn bei dieser Variante der Drehwinkel der optischen Achse des zweiten magnetischen Deflektors kleiner ist als der Drehwinkel der optischen Achse des ersten magnetischen Deflektors, dann ergibt sich die Möglichkeit einer Verringerung des Koeffizienten der sphärischen Aberration auch im Falle eines einlinsigen Bestandes der Steuerlinsen-Einheit auf dem Wege seiner Verlagerung hin zum ersten magnetischen Deflektor. In diesem Falle wird das technische Resultat mittels der Einwirkung von zwei Faktoren erzielt: der optischen Verstärkung der Steuerlinsen-Einheit und des Ansteigens des Koeffizienten der optischen Vergrößerung bei der Bildübertragung in den zweiten magnetischen Deflektor. Dabei ist es möglich (bei einem niedrigen Koeffizienten der sphärischen Aberration), die Konstruktion der Steuerlinsen-Einheit zu vereinfachen, indem sie einlinsig ausgeführt wird.

Wie durch die dargestellten Beispiele illustriert, ermöglicht die Variante mit den nicht identischen magnetischen Deflektoren für den Anwender eine große Flexibilität sowohl bei der Auswahl der konstruktiven Lösungen, als auch in Bezug auf die Ausgestaltung des ersten und zweiten magnetischen Deflektors, und in Bezug auf die Positionierung der Elemente Kompensators der energetischen Winkel-Dispersion. Die dargestellte Variante ist besonders interessant unter Bedingungen, wo eine Universalität der Konstruktion des korpuskular-optischen Systems besonders wichtig ist. Hier, bei erhöhten Anforderungen an die Qualität der Übertragung des optoelektronischen Bildes durch die Steuerlinsen-Einheit ist es erforderlich, auf der Grundlage der oben gemachten Aussagen die Ausführung der Steuerlinsen-Einheit auf der Basis von magnetischen Linsen zu bevorzugen.

In den Varianten des korpuskular-optischen Systems mit zwei magnetischen Deflektoren können zur Verbesserung des Kontrastes des Bildes vor jedem von ihnen, aber auch vor der Projektions-Einheit in den Crossover-Ebenen Apertur-Diaphragmen positioniert werden (gem. Anspruch 6).

Für die Komfortabilität des Einstellens des Aberrations-Korrektors und des Umschaltens des jeweiligen Arbeits-Modus der genannten Varianten des korpuskular-optischen Systems wird der zweite magnetische Deflektor auf der Basis der Berechnung bei einer Drehung der optischen Achsen um 60° ausgebildet (gem. Anspruch 7).

Möglich ist auch die Ausgestaltung jedes beliebigen der beiden magnetischen Deflektoren mit zylindrischen Begrenzungen der Polkappen, was ein flexibles Einstellen der mit den magnetischen Deflektoren konjugierten optischen Achsen erlaubt (gem. Anspruch 8).

Die negative Rückkopplung hinsichtlich der energetischen Winkel-Dispersion in allen Varianten der Ausgestaltung ist erforderlich für die Subtraktion der energetischen Winkel-Dispersion aus der energetischen Winkel-Dispersion des ersten magnetischen Deflektors. Sie realisiert sich in der Variante gemäß Anspruch 1 mittels Anlegen der entsprechenden Spannung an die Elektroden des elektrostatischen Spiegels und die Steuerlinsen-Einheit gleichzeitig mit dem Einstellen des Modus der aberrationsfreien Übertragung des Bildes. In den Varianten gemäß den Ansprüchen 3 und 4 wird die negative Rückkopplung hinsichtlich der energetischen Winkel-Dispersion realisiert durch das Abgleichen der Richtungen der der Polarität des ersten und zweiten magnetischen Deflektors in Abhängigkeit vom Übertragungsmodus-Modus des Bildes durch die Steuerlinsen-Einheit. Im umgekehrten Fall (bei positiver Rückkopplung) wird am Ausgang des Kompensators der energetischen Winkel-Dispersion keine Kompensation der energetischen Winkel-Dispersion erfolgen, sondern ihre Verdopplung.

Der hinsichtlich der Energie inhomogene korpuskulare (elektronische oder Ionen-) Strahl wird beim Passieren des Magnetfeldes des magnetischen Deflektors in ein räumliches energetisches Spektrum zerlegt mit einer energetischen Winkel-Dispersion, welche mittels des Kompensators der energetischen Winkel-Dispersion beseitigt wird. Daher gelangt der elektronische Informationsstrahl an den Eingang des Aberrations-Korrektors, ohne eine energetische Winkel-Dispersion aufzuweisen. Im Ergebnis dessen entsteht beim Passieren des Aberrations-Korrektors keine quadratische chromatische Aberration. Darin besteht auch die Ursache - Wirkung - Verbindung der eingebrachten Veränderungen mit dem erreichten technischen Resultat.

In der Variante der Ausführung des Kompensators der energetischen Winkel-Dispersion auf der Basis eines elektrostatischen Spiegels (gem. Anspruch 1) ist die Konstruktion des genannten Kompensators der energetischen Winkel-Dispersion eine völlig neue.

In der Ausführungsvariante des Kompensators der energetischen Winkel-Dispersion auf der Basis des zweiten magnetischen Deflektors, mit dem ersten magnetischen Deflektor identischen (gem. Anspruch 3), stimmen die Anzeichen des Vorhandenseins des zweiten magnetischen Deflektors , seiner Identität mit dem ersten magnetischen Deflektor, aber auch des Vorhandenseins der Steuerlinsen-Einheit mit derartigen Anzeichen einer energetischen Verlagerung des diffraktiven Bildes überein, wie es beschrieben ist in (US 2007200070, H01J 37/153, 37705, 37/26, 37/04 49/00; G01 N 23/225, 23/227, 23/22, 2007). Jedoch in der von uns vorgeschlagenen Lösung wird der Kompensator der energetischen Winkel-Dispersion für eine andere Zweckbestimmung genutzt (für die Beseitigung der quadratischen chromatischen Aberration bei der Übertragung des Bildes der Probe durch den Aberrations-Korrektor, weiterhin, wie die Zweckbestimmung der bekannten technischen Lösung - die Korrektur der chromatischen Zerlegung des diffraktiven Bildes, die im Prozess seiner Übertragung über den magnetischen Deflektor entsteht). Wesentlich ist, dass die Steuerlinsen-Einheit, ausgeführt entsprechend US 2007200070, lediglich eine elektrostatische Linse aufweist, positioniert in der Mitte zwischen den magnetischen Deflektoren, während in der diskutierten Variante der vorgeschlagenen technischen Lösung die Steuerlinsen-Einheit auf der Basis von mindestens zwei Linsen (sowohl elektrostatischen, als auch magnetischen) entsprechend den o. g. Gründen ausgestaltet ist.

Die Variante mit der Ausführung des Kompensators der energetischen Winkel-Dispersion auf der Basis von nicht identischen magnetischer Deflektoren (gem. Anspruch 4) unterscheidet sich in noch größerem Maße nicht nur im Zusammenhang mit der Nicht-Identität des ersten und des zweiten magnetischen Deflektors, sondern auch durch die sich daraus ergebende Beziehung der Gegenseitigkeit zwischen der erforderlichen Größe des Koeffizienten der optischen Vergrößerung bei der Bildübertragung durch die Steuerlinsen-Einheit und den Drehwinkeln der optischen Achsen im ersten und zweiten magnetischen Deflektor.

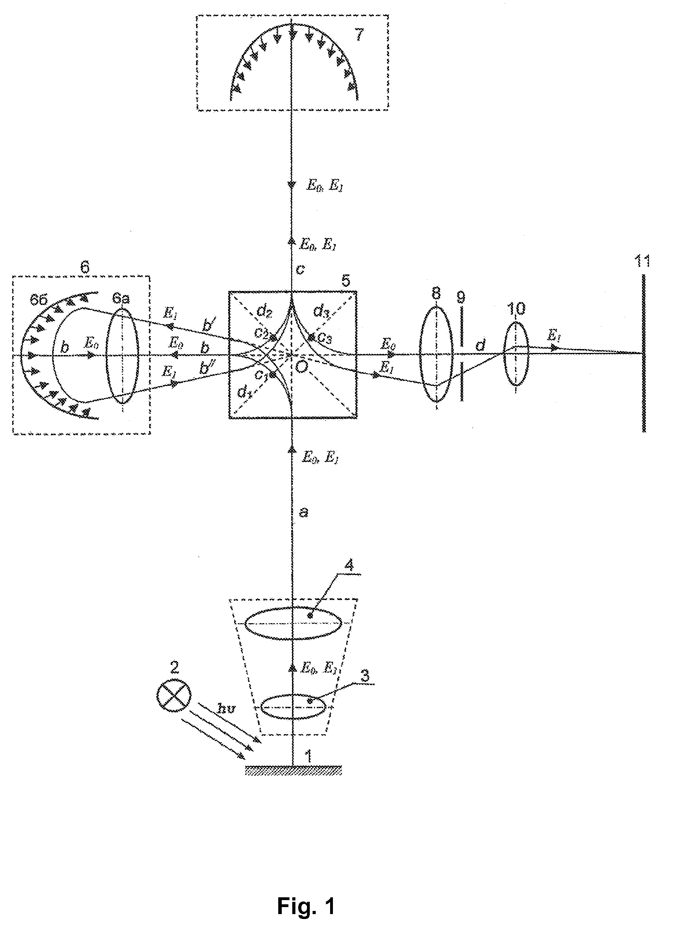

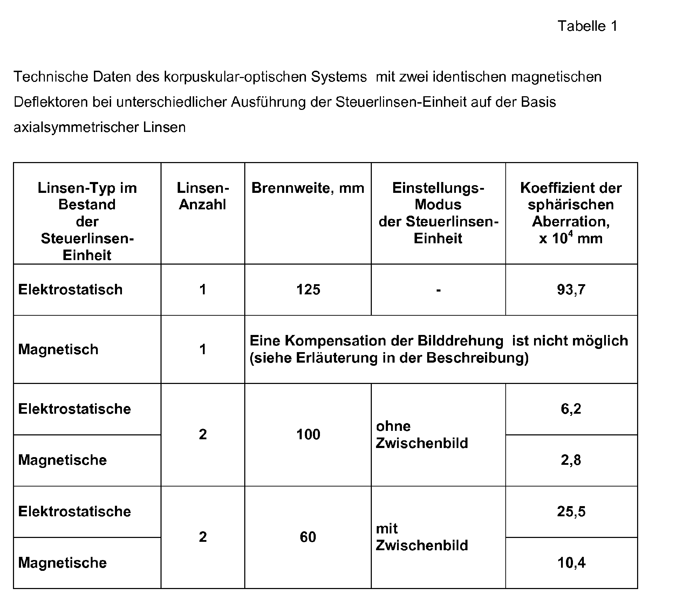

Auf den Fig. 1 bis 5 sind die möglichen technischen Realisierungen der angemeldeten Ausführungsvarianten des vorgeschlagenen korpuskular-optischen Systems schematisch dargestellt. In allen Varianten ist jeder der magnetischen Deflektoren ausgestaltet als flächenparalleles Paar magnetischer Polkappen, die symmetrisch zur Mittelebene (in welcher die optische Achse des magnetischen Deflektors liegt und in der die Erzeugung der energetischen Winkeldispersion erfolgt) angeordnet sind. In der Richtung, senkrecht zur Mittelebene fehlt die energetische Dispersion. Die optischen Achsen der magnetischen Deflektoren sind kreisbogenförmig gestaltet. Die Begrenzungen der Polkappen der magnetischen Deflektoren können sowohl zylindrisch als auch flächenförmig ausgeführt sein. Um die Fig. 1 bis 5 nicht zu komplizieren, wurden Details der Gestaltung bekannter Elemente weggelassen.

In der Variante gemäß Fig. 1 enthält das korpuskular-optische Bildgebungssystem ein Vakuum-System (nicht dargestellt), einen Arbeitstisch 1, auf welchem die Probe aufgebracht ist, eine Lichtquelle 2 zur Beleuchtung dieser Probe und ein in Richtung der Bildübertragung angeordnetes Objektiv mit den Linsen 3 und 4, einen vierkanaligen dispersiven magnetischen Deflektor (Drehwinkel der optischen Achse 90°), einen Kompensator der energetischen Winkel-Dispersion 6, der aus, seriell zur Bildübertragungsrichtung angeordnet, einer Übertragungslinsen-Einheit 6a und einem axialsymmetrischen elektrostatischen Spiegel 6b besteht, wobei diese in den Modus der aberrationsfreien Übertragung des reflektierten Bildes ins Zentrum des magnetischen Deflektors 5 eingestellt sind, mit Bildung einer negativen Rückkopplung hinsichtlich der energetischen Winkel-Dispersion, einen Aberrations-Korrektor 7, ausgestaltet auf der Basis eines axialsymmetrischen elektrostatischen Aberrationsspiegels, eine Übertragungslinsen-Einheit 8, ein kontrastives Apertur-Diaphragma 9, welches in der Crossover-Ebene positioniert ist, eine Projektions-Einheit 10 und einen Bildschirm 11. Die optischen Achsen $a$, $b$, $c$ und $d$ der Elemente 3, 4, 6 - 10 sind entlang der optischen Achse des korpuskular-optischen Systems angeordnet und seriell über den magnetischen Deflektors 5 gekoppelt. Hierbei bilden der mit dem zweifachen Durchlaufen des elektronischen Informationsstrahls verbundene Teil des magnetischen Deflektors 5, der Kompensator der energetischen Winkel-Dispersion 6, und die optische Achse b den kompensierenden Kanal des korpuskular-optischen Systems. Die optischen Achsen des Objektivs, des magnetischen Deflektors 5, des Aberrations-Korrektors 7, der Übertragungslinsen-Einheit 8, der Projektions-Einheit 10 und des Kompensators der energetischen Winkel-Dispersion 6 verlaufen senkrecht zu den entsprechenden Begrenzungen des magnetischen Deflektors 5.

Die Lichtquelle 2 ruft eine photoelektronische Emission an der Oberfläche der Probe hervor, die sich auf den Arbeitstisch 1 befindet. Die auf diese Weise emittierte elektronische Informationsstrahl wird durch das elektrische Feld des Objektivs bis zu einer gewissen Basisenergie beschleunigt und entlang der optischen Achse zum Eingang des magnetischen Deflektors 5 gelenkt, wo er unter der Einwirkung des magnetischen Feldes um einen Winkel von 90° abgelenkt wird. Zur Illustration dieses Prinzips der Erzeugung einer energetischen Winkel-Dispersion des elektronischen Informationsstrahls und seiner Korrektur wird die Bildübertragung lediglich eines zentralen Punktes der zu untersuchenden Probe auf den Bildschirm 11 gezeigt. Die Optik des Objektivs ist derart ausgebildet, dass das Bild des zentralen Punktes der Probe in das Zentrum des magnetischen Deflektors 5 projiziert wird, was wichtig ist für das Verhindern einer chromatischen Aberration des Bildes. Das reelle Bild dieses Punktes ist bezeichnet mit $c_1$ (angeordnet an der Schnittstelle der Winkelhalbierenden $d_1$ des Drehwinkels der optischen Achse im Feld des magnetischen Deflektors 5 mit der optischen Achse selbst). Nach dem Verlassen des magnetischen Deflektors 5 verläuft die weitere Bewegung des elektronischen Informationsstrahls entlang der optischen Achse b über die Steuerlinsen-Einheit 6a in Richtung zum elektrostatischen Spiegel 6b, durchläuft diesen und, reflektiert vom Feld dieses Spiegels, verläuft er in entgegengesetzter Richtung entlang der Achse b über die Steuerlinsen-Einheit 6a, und tritt erneut in den magnetischen Deflektor 5 ein, wo er unter der Einwirkung des Magnetfeldes erneut um 90° in Richtung der Achse c abgelenkt wird. Dabei reflektiert der Spiegel 6b das projizierte das Bild des zentralen Punktes der zu untersuchenden Probe über die Steuerlinsen-Einheit 6a in das Zentrum des magnetischen Deflektors 5. Das reelle Bild dieses Punktes wird dabei im Punkt $c_2$ am Schnittpunkt der Winkelhalbierenden $d_2$ des Drehwinkels der optischen Achse in Richtung zum Aberrations-Korrektor 7 und des entsprechenden Abschnittes der optischen Achse erzeugt. Nach dem Austritt aus dem magnetischen Deflektor 5 bewegt sich der elektronische Informationsstrahl entlang der Achse c in Richtung zum elektrostatischen Spiegel des Aberrations-Korrektors 7 und, dessen Feld mit Reflexion durchlaufend, bewegt er sich in entgegengesetzter Richtung entlang der Achse c zum magnetischen Deflektor 5, wo er unter der Einwirkung des magnetischen Feldes ein drittes Mal um 90° abgelenkt wird und aus dem magnetischen Deflektor 5 in Richtung der Achse d austritt.

Dabei überträgt der Spiegel des Aberrations-Korrektors 7 erneut das projizierte Bild des zentralen Punktes der Probe ins Zentrum des magnetischen Deflektors 5 mit seinem reellen Bild im Punkt $c_3$ der Schnittstelle der Winkelhalbierenden $d_3$ des Drehwinkels der optischen Achse in Richtung zur Übertragungslinsen-Einheit 8 und dem entsprechenden Abschnitt der optischen Achse. Nach dem Austritt aus dem magnetischen Deflektor 5 setzt der elektronische Informationsstrahl seine weitere Bewegung entlang der Achse d in Richtung des Bildschirmes 11 fort, verläuft durch die Übertragungslinsen-Einheit 8 , das Apertur-Diaphragma 9 und die Projektions-Einheit 10, mit deren Hilfe das Bild der Oberfläche der Probe bis zum geforderten Wert vergrößert und frei von chromatischer Dispersion auf den Bildschirm 11 übertragen wird.

Beim ersten Durchlaufen des magnetischen Deflektors 5 wird der energetisch inhomogene elektronische Informationsstrahl räumlich nach Energien aufgespalten, infolgedessen sich entlang der Achse b nur Elektronen mit der nominalen Energie $E_0$, jedoch Elektronen mit der Energie $E_1$, unterschiedlich von $E_0$, sich in Richtung zum Kompensator der energetischen Winkel-Dispersion 6 unter einem Winkel zur Achse b (in Fig. 1 ist zur Definition diese Situation ausgedrückt durch $E_1>E_0$, jedoch trifft das zuletzt Gesagte auch für Energien zu, geringer als $E_0$). Der aberrationsfreie elektrostatische Spiegel 6b gewährleistet die Reflexion der Elektronen zum magnetischen Deflektors 5 mit den Energien $E_1>E_0$ auf solchen Bahnen (*b'* und *b''*), dass die Elektronen, das zweite Mal den magnetischen Deflektor 5 durchlaufend, sich mit den genannten Energien entlang der gleichen Achse bewegen, wie auch die Elektronen mit der Energie $E_0$. Das wird durch das Einstellen der Spannung an den Elektroden der Steuerlinsen-Einheit 6a und des Spiegels 6b erreicht. Demzufolge tritt in den Aberrations-Korrektors 7 ein elektronischer Informationsstrahl ein, der keine energetische Winkel-Dispersion aufweist, weshalb das auf den Bildschirm projizierte Bild der Probe frei ist von quadratischer chromatischer Aberration. Dabei reflektiert der Spiegel des Aberrations-Korrektors 7 das projizierte Bild des zentralen Punktes der Probe in das Zentrum des magnetischen Deflektors 5. Das ist dem Umstand zu verdanken, dass, ungeachtet des Vorhandenseins einer energetischen Winkel-Dispersion des elektronischer Informationsstrahls, die nach seinem dem dritten Durchlaufen des magnetischen Deflektors 5 entstanden ist, das Bild der Probe mittels der Linsen der Übertragungslinsen-Einheit 8 und der Projektions-Einheit 10 auf den Bildschirm 11 frei von chromatischer Dispersion übertragen wird (die Elektronen des elektronischen Informationsstrahls, die aus dem Punkt der Probe ausgetreten sind, unabhängig von der Größe ihrer Anfangsenergie, werden auf dem Bildschirm 11 in einen Punkt fokussiert).

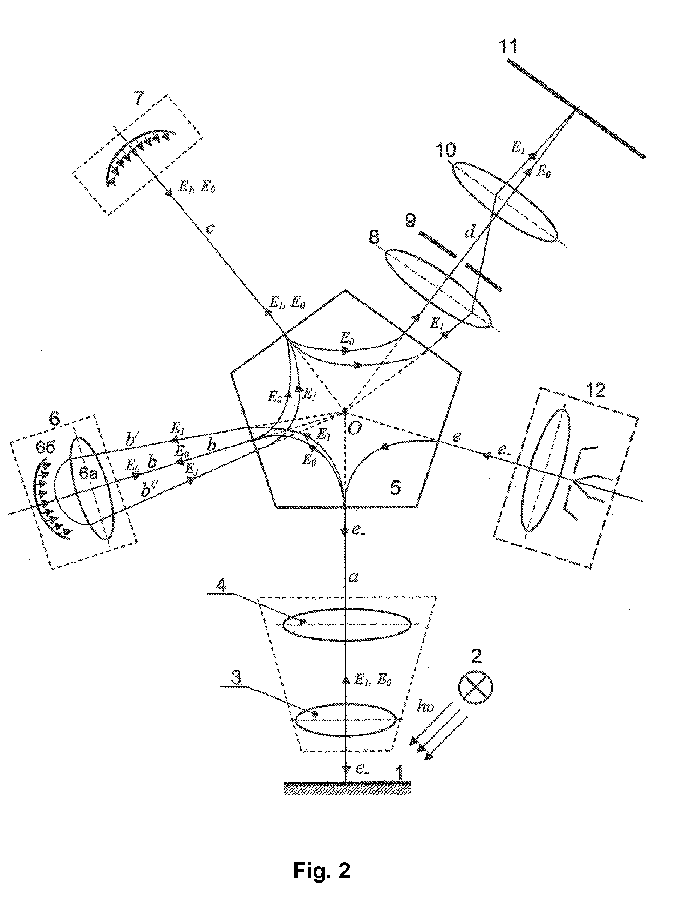

In Fig. 2 ist eine Variante der technischen Lösung bei Verwendung einer Elektronenkanone als Quelle für die Beleuchtung der zu untersuchenden Probe mit Elektronen geringer Energien dargestellt. Mit dem Ziel des Erhalts eines zusätzlichen Kanals für das installieren der Elektronenkanone, ist der magnetische Deflektor 5 fünfkantig ausgestaltet (im gezeigten Beispiel ist der Ablenkwinkel gleich 108°). Die fünfkantige Ausführung des magnetischen Deflektors wird erstmalig vorgeschlagen.

Das elektronenoptische Schema bei dieser Variante ist analog dem Beispiel 1 ausgeführt, mit einem zusätzlichen Kanal, in welchem die Elektronenkanone 12 installiert wird.

Der Elektronenstrahl, erzeugt durch die Elektronenkanone 12, wird entlang der Achse e zum magnetische Deflektor 5 bewegt, um 108° abgelenkt, verläuft er weiter zur Achse a in Richtung der Probe entlang der Normalen zu seiner Oberfläche. Durch das optische System der Elektronenkanone 12 und durch die Linse 4 wird der leuchtende Elektronenstrahl in die Brennebene der Linse 3 des Objektivs fokussiert. Nach dem Durchlaufen des Objektivs verlangsamt sich dieser Strahl bis zur gewünschten Energie und, praktisch parallel geworden durch das Einwirken des elektrischen Feldes des Objektivs, beleuchtet er die Oberfläche der Probe entlang der Normalen zu Ihr. In diesem Falle entsteht eine kohärente Elektronen-Elektronen-Emission von der Oberfläche der Probe, im Ergebnis dessen sich der elektronische Informationsstrahl bildet.

Nach dem Durchlaufen des Feldes des Objektivs gelangt der elektronische Informationsstrahl entlang der Achse *a* zum magnetische Deflektor 5, durchläuft ihn, wird dabei um 108° abgelenkt und tritt zur Achse b aus, bewegt sich in Richtung des Kompensators der energetischen Winkel-Dispersion 6, durchläuft diesen, wird im Feld des Spiegels 6b reflektiert, bewegt sich entlang der Achse b in Richtung zum magnetischen Deflektor 5, wird erneut im Winkel von 108° abgelenkt und tritt aus zur Achse c in Richtung zum Aberrations-Korrektor 7, wobei er keine energetische Winkel-Dispersion aufweist. Nach dem Passieren des Aberrations-Korrektors 7, mit einer Reflexion im Feld von dessen Spiegel, kehrt der elektronische Informationsstrahl entlang der Achse c zum magnetischen Deflektor 5 zurück. Weiter, das Feld des magnetischen Deflektor 5 durchlaufend, wird elektronische Informationsstrahl erneut um einen Winkel von 108° abgelenkt , tritt auf die Achse d aus, passiert die Übertragungslinsen-Einheit 8, das Apertur-Diaphragma 9 und die Projektionseinheit 10, wobei ein vergrößertes Bild der Probe, frei von quadratischer chromatischer Aberration, sphärischer chromatischer Aberration und chromatischer Dispersion auf den Bildschirm übertragen wird.

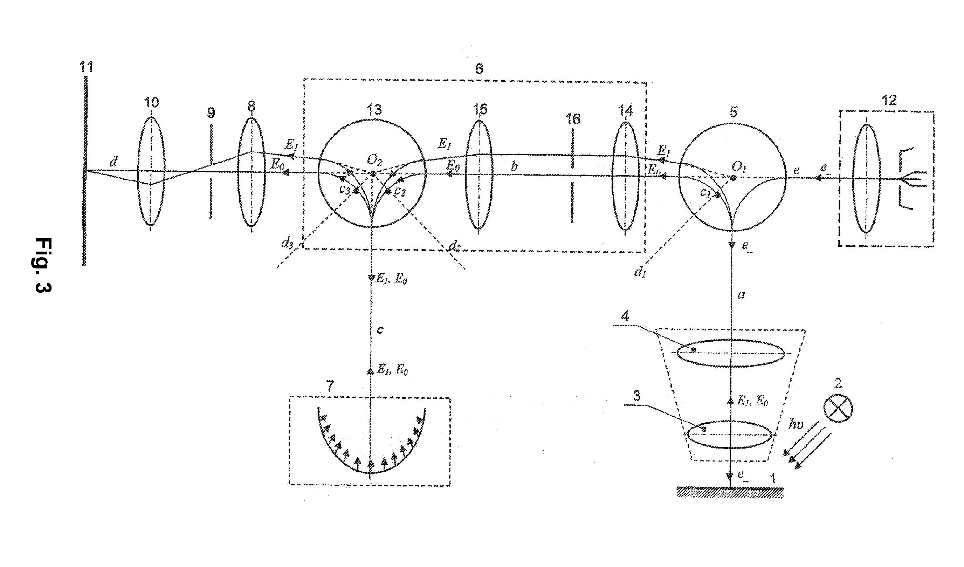

In der Variante gem. Fig. 3 enthält das korpuskular-optische Bildgebungssystem ein Vakuum-System (nicht dargestellt), einen Arbeitstisch 1 mit der Probe, eine Lichtquelle 2 zur Beleuchtung der vorliegenden Probe, ein Objektiv mit den Linsen 3 und 4, und, seriell angeordnet in Richtung der Übertragung des durch das Objektiv erzeugten Bildes, einen ersten dispersiven magnetischen Deflektor 5, einen Aberrations-Korrektor 7, ausgestaltet auf der Basis eines axialsymmetrischen elektrostatischen Aberrationsspiegels, eine Übertragungslinsen-Einheit 8, eine Apertur-Diaphragma 9, positioniert in der Crossover-Ebene, und eine Projektions-Einheit 10 mit einem Bildschirm 11. Auf dem Übertragungsweg des Bildes vom ersten magnetischen Deflektor 5 zum Aberrations-Korrektor 7 ist ein Kompensator der energetischen Winkel-Dispersion 6 angeordnet, der aus, seriell entlang der Bildübertragungsrichtung angeordnet, einer axialsymmetrischen Steuerlinsen-Einheit im Bestand der Linsen 14 und 15 besteht, zwischen denen in der Crossover-Ebene ein Apertur-Diaphragma positioniert ist, sowie eine zweiten magnetischen Deflektor 13, der identisch zum ersten magnetischen Deflektor 5 ausgestaltet ist. Die Magnetlinsen 14 und 15 sind gleich weit entfernt von den nächstliegenden Begrenzungen der magnetischen Deflektoren 5 und 13, entsprechend auch eingestellt auf der Basis der Berechnungen der Bildübertragung ins Zentrum des zweiten magnetischen Deflektors 13 bei einem Koeffizienten der optischen Vergrößerung gleich 1, mit Bildung eines Schaltkreises für eine negative Rückkopplung hinsichtlich der energetischen Winkel-Dispersion mittels einer nur einseitig ausgerichteten Polarität des magnetischen Deflektors 5 und des magnetischen Deflektors 13.

Die Lichtquelle 2 ruft eine photoelektronische Emission an der Oberfläche der Probe hervor, die sich auf den Arbeitstisch 1 befindet. Die auf diese Weise emittierte elektronische Informationsstrahl wird durch das elektrische Feld des Objektivs bis zu einer gewissen Basisenergie beschleunigt und über die Linse 4 entlang der Achse a zum Eingang des magnetischen Deflektors 5 gelenkt, wo sie um einen Winkel von 90° abgelenkt wird. Die Linsen 3 und 4 sind derart eingestellt, dass das Bild des zentralen Punktes der zu untersuchenden Probe ins Zentrum des magnetischen Deflektors 5 projiziert wird. Das Bild des Crossovers des elektronischen Informationsstrahls wird durch die Linse 4 aus der Fokalebene des Objektivs (wo anfänglich das Crossover formiert wird) in die Ebene des Apertur-Diaphragmas 16 übertragen. Nach dem Austritt aus dem magnetischen Deflektor 5 bewegt sich der elektronische Informationsstrahl weiter entlang der Achse b in Richtung des magnetischen Deflektors 13 durch die Linsen 14 und 15, welche das projizierte Bild des zentralen Punktes der Probe aus dem Zentrum $O_1$ des magnetischen Deflektors 5 ins Zentrum $O_2$ des magnetischen Deflektors 13 übertragen, mit einem Koeffizienten für die optische Vergrößerung gleich 1. Die Polarität des magnetischen Deflektors 13 ist so eingestellt, dass am Ausgang des magnetischen Deflektors 13 die energetische Winkel-Dispersion verschwindet, im Ergebnis dessen sich die Elektronen unterschiedlicher Energien entlang der einheitlichen Achse c in Richtung des Aberrations-Korrektors 7 bewegen. Daher bildet sich keine quadratische chromatische Aberration, nachdem der elektronische Informationsstrahl den Aberrationsspiegels des Aberrations-Korrektors 7 durchlaufen hat.

Der Spiegel des Aberrations-Korrektors 7 reflektiert den elektronischen Informationsstrahl zum magnetischen Deflektor 13, indem das projizierte Bild des zentralen Punktes der Probe erneut in das Zentrum des magnetischen Deflektors 13 übertragen wird. Beim Eintritt in das Feld des Letzteren wird der elektronische Informationsstrahl ein weiteres Mal um 90° abgelenkt in Richtung der Übertragungslinsen-Einheit 8. Beim Austritt aus dem Feld des magnetischen Deflektors 13 bewegt sich der elektronische Informationsstrahl über die Übertragungslinsen-Einheit 8, das Apertur-Diaphragma 9 und die Projektionseinheit 10, die ein von quadratischer chromatischer Aberration, sphärischer chromatischer Aberration und chromatischer Dispersion freies Bild der Probe auf den Bildschirm überträgt. Im Modus mit Beleuchtung der Probe durch die Elektronenkanone 12 arbeitet das System analog.

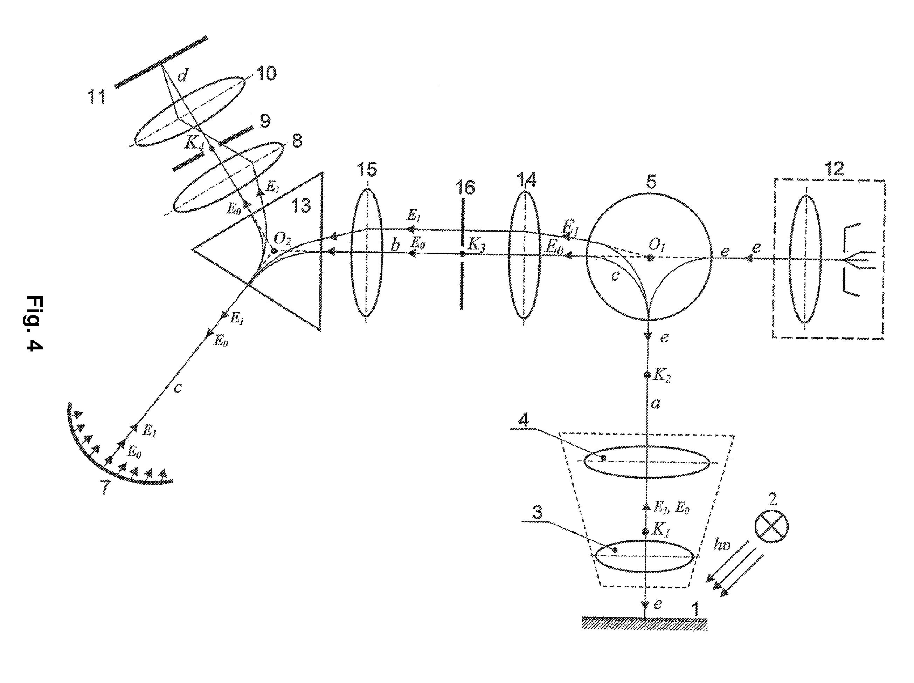

In der Variante des korpuskular-optischen Bildgebungssystems gem. Fig. 4 sind die Begrenzungen der Polkappen des ersten magnetischen Deflektors 5 zylindrisch gestaltet, aber der Ablenkungswinkel der optischen Achse in ihm ist eingestellt genau auf 90° mit Bildung von drei Nutz- und eines optischen Reservekanals; die Begrenzungen des magnetischen Deflektors 13 sind als Ebenen gestaltet, und der Ablenkwinkel der optischen Achse in ihm ist eingestellt auf 60° mit Bildung von drei optischen Nutzkanälen. Die übrigen Elemente des korpuskular-optischen Systems sind ausgestaltet und angeschlossen wie in Fig. 3, mit der Veränderung, dass resultierend aus der Nicht-Identität der magnetischen Deflektoren 5 und 13 die Linsen 14 und 15 der Steuerlinsen-Einheit eingestellt sind auf der Basis der Berechnung der Übertragung des Bildes der Probe in das Zentrum des zweiten magnetischen Deflektors 13 bei einem Koeffizienten der optischen Vergrößerung gleich dem Verhältnis der Sinus-Werte der Drehwinkel der optischen Achsen des ersten und zweiten magnetischen Deflektors, nämlich:

$$M = \frac{\sin(90°)}{\sin(60°)} = \frac{2}{\sqrt{3}} = 1,16$$

wobei M - Koeffizient der optischen Vergrößerung.

Die Punkte $K_1$ - $K_4$ in Fig. 4 zeigen die Lage der Crossover an, in welchen Apertur-Diaphragmen zur Verbesserung des Kontrastes des Bildes positioniert werden können.

Die Arbeit dieser Variante des korpuskular-optischen Systems ist anlog der Variante gemäß Fig. 3. Dabei wird ein zusätzlicher Komfort für das Einstellen des korpuskular-optischen Systems zur Verfügung gestellt. Dabei wird die Möglichkeit einer Ablenkung des Kanals, in welchem der Aberrations-Korrektor 7 positioniert ist, auf dem Wege einer Änderung der Polarität des magnetischen Deflektors 13 geboten, was günstig für eine autonome Einstellung der entsprechenden anderen Teile des Systems ist.

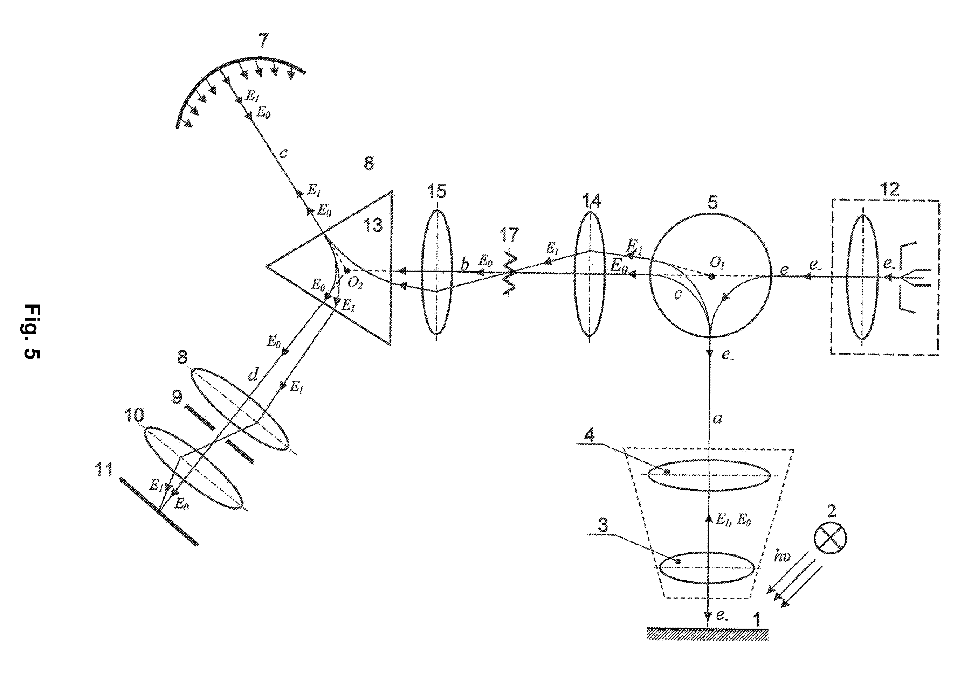

Die Ausführungsvariante des korpuskular-optischen Systems gemäß Fig. 5 ist analog zur vorgestellten Variante gemäß Fig. 4, mit der wesentlichen Veränderung, dass die Linsen 14 und 15 der Steuerlinsen-Einheit im Modus zur Erzeugung eines Zwischenbildes in Pos. 17 eingestellt sind, wo ein Feld-Diaphragma positioniert ist. Dabei wird zur Realisierung der negativen Rückkopplung hinsichtlich der energetischen Winkel-Dispersion die Polarität des zweiten magnetischen Deflektors 13 verändert. In diesem Falle wird die Bewegungsrichtung des elektronischen Informationsstrahls im magnetischen Deflektor 13 geändert, in Verbindung damit entsprechend ändert man die Position des Aberrations-Korrektors 7 und des optischen Strahlenganges d in Bezug auf den Arbeitstisch 1.

Somit gewährleistet die Benutzung der vorgeschlagenen Erfindung eine Erhöhung des Auslösungsvermögens des korpuskular-optischen Systems mittels des Ausschließens der Ursachen für die Entstehung einer quadratischen chromatischen Aberration bei Erhaltung der korrigierenden Funktion des Aberrations-Korrektors unter den Bedingungen der Nutzung eines dispersiven magnetischen Deflektors. Das erreichte technische Resultat der Lösung ist die Erweiterung der funktionalen Möglichkeiten des korpuskular-optischen Systems mittels der Bildung zusätzlicher optischer Kanäle für das Installieren der Elektronenkanone und/ oder anderer spezieller Vorrichtungen.

**Patentansprüche**

1. Korpuskular-optisches Bilderzeugungs-System mit:

- einem Vakuum-System;
- einem Arbeitstisch mit einer Probe;
- einer Lichtquelle zur Beleuchtung der vorliegenden Probe;
- einem Objektiv,
sowie, seriell angeordnet in Richtung der Übertragung des durch das Objektiv erzeugten Bildes,
- einem dispersiven magnetischen Deflektor;
- einem Aberrations-Korrektor, ausgebildet auf der Basis eines axialsymmetrischen, elektrostatischen Aberrationsspiegels;
- einer Übertragungslinsen-Einheit, und
- einer Projektions-Einheit,
**dadurch gekennzeichnet,**
**dass** auf einem Bildübertragungsweg vom magnetischen Deflektor zum Aberrations-Korrektor ein Kompensator der energetischen Winkeldispersion positioniert ist, der, seriell zur Bildübertragungsrichtung angeordnet, aus einer axialsymmetrischen Einheit steuernder elektronischer Linsen und einem axialsymmetrischen elektrostatischen Spiegel besteht,
wobei diese auf den Modus für eine aberrationsfreie Bildübertragung in das Zentrum des magnetischen Deflektors mit einem Koeffizienten für die optische Vergrößerung gleich 1 eingestellt sind, und
wobei eine negative Rückkopplung hinsichtlich der energetischen Winkeldispersion gebildet wird.

2. Korpuskular-optisches System nach Anspruch 1,
**dadurch gekennzeichnet,**
**dass** der magnetische Deflektor ausgebildet ist auf der Basis der Berechnung der Änderung der optischen Achsen um einen Winkel, entsprechend einem Vielfachen von 36°, für die Möglichkeit einer elektronischen Beleuchtung der Probe.

3. Korpuskular-optisches Bilderzeugungs-System mit:

- einem Vakuum-System;
- einem Arbeitstisch mit einer Probe;
- einer Lichtquelle zur Beleuchtung der vorliegenden Probe;
- einem Objektiv,
sowie, seriell angeordnet zur Übertragungsrichtung des durch das Objektiv erzeugten Bildes,
- einem ersten dispersiven magnetischen Deflektor;
- einem Aberrations-Korrektor, ausgebildet auf der Basis eines axialsymmetrischen, elektrostatischen Aberrationsspiegels ;
- einer Übertragungslinsen-Einheit, und
- einer Projektions-Einheit,
**dadurch gekennzeichnet,**
**dass** auf dem Bildübertragungsweg vom ersten magnetischen Deflektor zum Aberrations-Korrektor ein Kompensator der energetischen Winkeldispersion positioniert ist, der, seriell entlang der Bildübertragungsrichtung angeordnet, aus einer axialsymmetrischen Steuerlinsen-Einheit und einem zweiten magnetischen Deflektor besteht, welcher mit dem ersten magnetischen Deflektor identisch ist,

wobei die Steuerlinsen-Einheit mindestens zwei Linsen umfasst und auf der Basis der Berechnung der Bildübertragung ins Zentrum eines zweiten magnetischen Deflektors ausgebildet ist mit einem Koeffizienten für die optische Vergrößerung gleich 1, mit Bildung einer negativen Rückkopplung hinsichtlich der energetischen Winkeldispersion.

4. Korpuskular-optisches Bilderzeugungs-System mit:

- einem Vakuum-System;
- einem Arbeitstisch mit Probe;
- einer Lichtquelle zur Beleuchtung der vorliegenden Probe;
- einem Objektiv,

sowie, seriell angeordnet zur Bildübertragungsrichtung des durch die Objektiv-Linse erzeugten Bildes,

- einem ersten dispersiven magnetischen Deflektor;
- einem Aberrations-Korrektor, ausgebildet auf der Basis eines axialsymmetrischen, elektrostatischen Aberrationsspiegels;
- einer Übertragungslinsen-Einheit, und
- einer Projektions-Einheit,

**dadurch gekennzeichnet,**

**dass** auf dem Bildübertragungsweg vom ersten magnetischen Deflektor zum Aberrations-Korrektor ein Kompensator der energetischen Winkeldispersion positioniert ist, der, seriell entlang der Bildübertragungsrichtung angeordnet, aus einer axialsymmetrischen Steuerlinsen-Einheit und einem zweiten magnetischen Deflektor besteht, welcher nicht mit dem ersten magnetischen Deflektor identisch ist, wobei die Steuerlinsen-Einheit ausgebildet ist auf der Basis der Berechnung der Bildübertragung ins Zentrum eines zweiten magnetischen Deflektors mit einem Koeffizienten für die optische Vergrößerung gleich dem Verhältnis der Sinuswerte der Drehwinkel der optischen Achsen des ersten und zweiten magnetischen Deflektors, mit Bildung einer negativen Rückkopplung hinsichtlich der energetischen Winkeldispersion.

5. Korpuskular-optisches System nach den Ansprüchen 3 oder 4,

**dadurch gekennzeichnet,**

**dass** die Steuerlinsen-Einheit eingestellt ist auf der Basis der Berechnung für die Erzeugung eines Zwischenbildes innerhalb dieser Einheit, wobei in der Zwischenbildebene ein Feld-Diaphragma positioniert ist.

6. Korpuskular-optisches System nach den Ansprüchen 3 oder 4,

**dadurch gekennzeichnet,**

**dass** in den Crossover-Ebenen vor dem ersten magnetischen Deflektor, zwischen den magnetischen Deflektoren und vor der Projektions-Einheit Apertur-Diaphragmen positioniert sind.

7. Korpuskular-optisches System nach den Ansprüchen 3 oder 4,

**dadurch gekennzeichnet,**

**dass** der zweite magnetische Deflektor ausgebildet ist auf der Basis der Berechnung bei einer Drehung der optischen Achsen um 60° zur Realisierung einer komfortablen Einstellung und Nutzung des Systems.

8. Korpuskular-optisches System nach den Ansprüchen 1, 3 oder 4,

**dadurch gekennzeichnet,**

**dass** der erste und/oder der zweite magnetische Deflektor mit zylindrischen Begrenzungen der Polkappen ausgebildet ist/sind.

**Fig. 1**

**Fig. 2**

**Fig. 3**

**Fig. 4**

Fig. 5

Tabelle 1

Technische Daten des korpuskular-optischen Systems mit zwei identischen magnetischen Deflektoren bei unterschiedlicher Ausführung der Steuerlinsen-Einheit auf der Basis axialsymmetrischer Linsen

| Linsen-Typ im Bestand der Steuerlinsen-Einheit | Linsen-Anzahl | Brennweite, mm | Einstellungs-Modus der Steuerlinsen-Einheit | Koeffizient der sphärischen Aberration, x $10^4$ mm |
|---|---|---|---|---|
| Elektrostatisch | 1 | 125 | - | 93,7 |
| Magnetisch | 1 | Eine Kompensation der Bilddrehung ist nicht möglich (siehe Erläuterung in der Beschreibung) | | |
| Elektrostatische | 2 | 100 | ohne Zwischenbild | 6,2 |
| Magnetische | | | | 2,8 |
| Elektrostatische | 2 | 60 | mit Zwischenbild | 25,5 |
| Magnetische | | | | 10,4 |

## INTERNATIONAL SEARCH REPORT

| International application No. |
| --- |
| PCT/RU2008/000007 |

**A. CLASSIFICATION OF SUBJECT MATTER**

H01J 37/153 (2006.01)

According to International Patent Classification (IPC) or to both national classification and IPC

**B. FIELDS SEARCHED**

Minimum documentation searched (classification system followed by classification symbols)

H01J 37/00, 37/02, 37/04, 37/10, 37/12, 37/147, 37/153, 37/26, 3/00, 3/02, 3/14, G21K 1/00

Documentation searched other than minimum documentation to the extent that such documents are included in the fields searched

Electronic data base consulted during the international search (name of data base and, where practicable, search terms used)

RUPAT, RUABRU, RUPAT OLD, RUABU1, Esp@cenet, PAJ, USPTO DB

**C. DOCUMENTS CONSIDERED TO BE RELEVANT**

| Category* | Citation of document, with indication, where appropriate, of the relevant passages | Relevant to claim No. |
| --- | --- | --- |
| A | US 5319207 A (CARL-ZEISS-STIFTUNG) 07.06.1994 | 1-8 |
| A | US 2006/0060789 A1 (STEVEN ROBERT ROGERS) 23.03.2006 | 1-8 |
| A | EP 1770752 A2 (JEOL LTD) 04.04.2007 | 1-8 |
| A | SU 355667 A (G.V. DER-SHVARTS et al.) 03. H .1972 | 1-8 |
| A | SU 1048532 A (PETROV I.A. et al.) 15.10.1983 | 1-8 |

☐ Further documents are listed in the continuation of Box C.    ☐ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 20 June 2008 | 03 July 2008 |

| Name and mailing address of the ISA/ RU | Authorized officer |
| --- | --- |
| Facsimile No. | Telephone No. |

Form PCT/ISA/210 (second sheet) (April 2005)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1313125 A
- EP 1770752 A
- US 2004188613 A
- JP 2005310512 B
- DE 60032972 D
- US 2003183781 A
- JP 2005228743 B
- JP 5205687 B
- US 5319207 A
- US 4740704 A
- EP 0647960 A
- US 2007200070 A

**In der Beschreibung aufgeführte Nicht-Patentliteratur**

- *Surface Review and Letters,* 1998, vol. 5 (6), 1191
- *Journal of Electron Microskopy,* 1997, vol. 46 (1), 9
- *Surface Review and Letters,* 1998, vol. 5 (6), 1251